(19) **Europäisches Patentamt**
**European Patent Office**
**Office européen des brevets**

(11) **EP 1 490 700 B1**

(12) **EUROPÄISCHE PATENTSCHRIFT**

(45) Veröffentlichungstag und Bekanntmachung des Hinweises auf die Patenterteilung:
**04.06.2008 Patentblatt 2008/23**

(21) Anmeldenummer: **03708005.8**

(22) Anmeldetag: **24.01.2003**

(51) Int Cl.:
***G01R 19/165*** *(2006.01)*

(86) Internationale Anmeldenummer:
**PCT/DE2003/000188**

(87) Internationale Veröffentlichungsnummer:
**WO 2003/081263 (02.10.2003 Gazette 2003/40)**

(54) **SCHALTUNGSANORDNUNG UND VERFAHREN ZUM ÜBERPRÜFEN EINES STROMKREISES**

CIRCUIT ARRANGEMENT AND METHOD FOR TESTING AN ELECTRIC CIRCUIT

DISPOSITIF ET PROCEDE DE CONTROLE D'UN CIRCUIT ELECTRIQUE

(84) Benannte Vertragsstaaten:
**DE ES FR GB**

(30) Priorität: **22.03.2002 DE 10212685**

(43) Veröffentlichungstag der Anmeldung:
**29.12.2004 Patentblatt 2004/53**

(73) Patentinhaber: **ROBERT BOSCH GMBH**
**70442 Stuttgart (DE)**

(72) Erfinder: **KNECHT, Gerhard**
**76473 Iffezheim (DE)**

(56) Entgegenhaltungen:
**GB-A- 2 360 335          US-A- 3 934 239**

- **PATENT ABSTRACTS OF JAPAN vol. 2000, no. 14, 5. März 2001 (2001-03-05) & JP 2000 329799 A (HARNESS SYST TECH RES LTD;SUMITOMO WIRING SYST LTD; SUMITOMO ELECTRIC), 30. November 2000 (2000-11-30)**

Printed by Jouve, 75001 PARIS (FR)

## Beschreibung

Die Erfindung betrifft eine Schaltungsanordnung mit einem Stromkreis gemäß dem Oberbegriff des Patentanspruchs 1 und ein Verfahren zum Überprüfen eines Stromkreises gemäß dem Oberbegriff des Patentanspruchs 10.

Stromkreise werden in den verschiedensten technischen Bereichen zur Versorgung von Verbrauchern eingesetzt. Bei der Versorgung eines Verbrauchers, insbesondere bei der Versorgung eines Verbrauchers in einem Kraftfahrzeug, bei dem der Verbraucher sicherheitsrelevante Funktionen ausführt, ist die Überprüfung der Stromversorgung ein wesentlicher Sicherheitsaspekt. Die Stromversorgung ist für eine korrekte Funktionsfähigkeit des sicherheitsrelevanten Verbrauchers erforderlich und muss deshalb in Bezug auf einen Ausfall oder in Bezug auf eine Fehlleistung überprüft werden.

Es ist bereits bei sicherheitskritischen Systemen wie z.B. bei einer elektromechanischen Bremse eines Kraftfahrzeuges bekannt, einen Stromsensor im Stromkreis vorzusehen und über den Stromsensor den im Stromkreis fließenden Strom zu erfassen, mit einem Vergleichswert zu vergleichen und abhängig von dem Vergleichsergebnis eine Fehlfunktion oder eine korrekte Funktion des Stromkreises zu erkennen. Wird beispielsweise über den Stromkreis ein elektronisch kommutierter Motor angetrieben, so wird über den Stromsensor der Phasenstrom gemessen und das vom Motor abzugebende Drehmoment mithilfe einer Phasenstromregelung eingestellt. Gleichzeitig wird die korrekte Funktionsfähigkeit über die Strommessung durch den Stromsensor überwacht. Dies ist z.B. in der US 3 934 239 offenbart.

Die Aufgabe der Erfindung besteht darin, eine Schaltungsanordnung und ein Verfahren zum Versorgen eines Verbrauchers bereitzustellen, das eine zuverlässige Überprüfung der Funktionsfähigkeit der Stromversorgung ermöglicht.

Die Aufgabe der Erfindung wird durch die Schaltungsanordnung gemäß Anspruch 1 und durch das Verfahren gemäß Anspruch 10 gelöst.

Ein wesentlicher Vorteil der erfindungsgemäßen Schaltungsanordnung besteht darin, dass ein zweiter Stromsensor im Stromkreis vorgesehen ist, und dass über den zweiten Stromsensor der Stromfluss im Stromkreis redundant erfassbar ist. Somit ist es möglich, aufgrund des zweiten Stromsensors eine korrekte Funktionsweise des ersten Stromsensors zu überprüfen. Liefert beispielsweise der erste Stromsensor in den Ausführungsformen des Standes der Technik ein fehlerhaftes Signal, so wird dieses zumindest nicht sofort als Fehlsignal erkannt. Im Gegensatz dazu bietet die Ausführungsform gemäß Anspruch 1 den Vorteil, den Stromkreis unabhängig vom ersten Stromsensor zu überprüfen. Somit ist eine doppelte Sicherheit für eine korrekte Überwachung des Stromkreises gegeben.

Vorzugsweise ist der zweite Stromsensor in den Stromkreis zuschaltbar, so dass der zweite Stromsensor nur bei Überprüfung des Stromkreises den Stromkreis elektrisch beeinflusst. Somit wird eine zuverlässige Überwachung bereitgestellt, ohne dass die elektrischen Eigenschaften des Stromkreises negativ beeinflusst werden.

In einer einfachen Ausführungsform ist ein Schalter vorgesehen, über den der zweite Stromsensor an den Stromkreis ankoppelbar ist. Vorzugsweise ist ein weiterer Schalter vorgesehen, mit dem der Verbraucher vom Stromkreis abkoppelbar ist. Auf diese Weise wird gewährleistet, dass eine Überprüfung des Stromkreises möglich ist, ohne dass der Verbraucher einen elektrischen Einfluss auf den Stromkreis hat.

Vorzugsweise wird der zweite Stromsensor in Form eines Widerstandes ausgebildet. Ein Spannungsabfall über den Widerstand kann als Messgröße erfasst werden, um den Stromfluss im Stromkreis zu bewerten. Die Verwendung eines Widerstandes als Stromsensor ist kostengünstig und ermöglicht ein zuverlässiges Verfahren.

Vorzugsweise wird mit der erfindungsgemäßen Schaltungsanordnung ein elektrischer Antrieb, insbesondere eine Wicklung des elektrischen Antriebes überprüft. Insbesondere eignet sich die erfindungsgemäße Schaltungsanordnung zur Überprüfung eines sicherheitsrelevanten Verbrauchers in einem Kraftfahrzeug, wie beispielsweise einer elektromechanischen Bremse.

In einer bevorzugten Anwendung wird der zweite Stromsensor zwischen zwei Highside-Schaltern und den entsprechenden Zuleitungen zu Wicklungen eines elektronisch kommutierten Motors eingesetzt. In dieser Ausführungsform kann auf einen Schalter zum Zu- oder Abschalten des Stromsensors verzichtet werden. Durch die gewählte Anbindung hat der Stromsensor keine merklichen Effekte auf den Betrieb des Motors. Somit ist eine kostengünstige Ausführung der erfindungsgemäßen Schaltungsanordnung möglich, da der Stromsensor, insbesondere in Form eines Widerstandes, in einer integrierten Schaltung mitintegriert werden kann.

Vorzugsweise ist der zweite Stromsensor bei der Überprüfung des Stromflusses in Serie mit einer Wicklung eines elektronisch kommutierten Motors geschaltet. Somit kann neben der Überprüfung des Stromflusses auch die Funktionsfähigkeit der Wicklung des Motors überprüft werden.

Die Erfindung wird im Folgenden anhand der Figuren näher erläutert.

Es zeigen

Fig. 1 eine schematische Darstellung der erfindungsgemäßen Schaltungsanordnung und
Fig. 2 einen Ausschnitt einer Ansteuereinheit für eine elektromechanische Bremse, bei der die erfindungsgemäße Schaltungsanordnung eingesetzt ist.

Das Grundprinzip der Erfindung ist in den verschiedensten technischen Bereichen einsetzbar. Beispielsweise können sicherheitsrelevante Schaltungen im Bereich der Gebäudetechnik, im Bereich der Luftfahrt, der Steuerungstechnik, für Kernkraftwerke oder im Bereich der Kraftfahrzeugtechnik eingesetzt werden. Die erfindungsgemäße Schaltungsanordnung und das erfindungsgemäße Verfahren bieten unabhängig von dem Einsatzgebiet eine erhöhte Sicherheit bei der Überprüfung eines Stromkreises.

Die Erfindung wird im Folgenden am Beispiel einer elektromechanischen Bremse für ein Kraftfahrzeug näher erläutert.

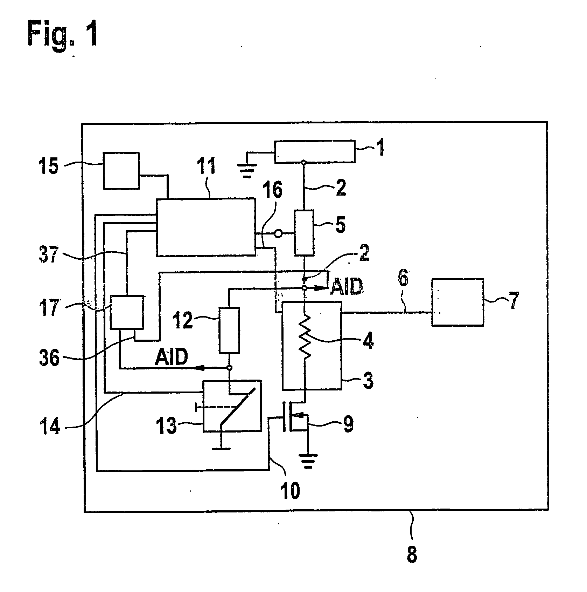

Fig. 1 zeigt in einer vereinfachten Darstellung das Grundprinzip der erfindungsgemäßen Schaltungsanordnung. Es ist eine Gleichspannungsquelle 1 vorgesehen, die eine festgelegte Gleichspannung liefert. Die Gleichspannungsquelle steht über eine Stromleitung 2 und einen Stromsensor 5 mit einem elektrischen Antrieb 3 in Verbindung. Der elektrische Antrieb 3 stellt beispielsweise einen elektronisch kommutierten Motor dar, der Wicklungen 4 aufweist. Ein elektronischer kommutierter Motor ist hinreichend bekannt und beispielsweise in dem "Handbuch der elektrischen Anlagen und Maschinen", Springer-Verlag, Egbert Hering, 1999, ISBN 3-540-65184-5 in Kapitel A.5.1.3, Seite 203 ff. beschrieben. Der Antrieb 3 steht über eine Antriebsstange 6 mit Stellgliedern einer elektromechanischen Bremse 7 in Wirkverbindung. Der Antrieb 3 steuert über die Antriebsstange 6 die Funktionsweise der elektromechanischen Bremse 7. Der Antrieb 3 ist über einen ersten Schalter 9, der vorzugsweise als Feldeffekttransistor ausgebildet ist, mit einem Massepotenzial verbindbar. Der erste Schalter 9 steht über eine Steuerleitung 10 mit einem Steuergerät 11 in Verbindung.

Zwischen dem Stromsensor 5 und dem Antrieb 3 ist ein zweiter Stromsensor 12 an die Stromleitung 2 angeschlossen. Der zweite Stromsensor 12 kann in einer einfachen Ausführungsform in Form eines definierten Widerstandes ausgebildet sein. Ein Ausgang des zweiten Stromsensors 12 ist über einen zweiten Schalter 13 mit Masse verbindbar. Der zweite Schalter 13 steht über eine zweite Steuerleitung 14 mit dem Steuergerät 11 in Verbindung. Das Steuergerät 11 ist zudem an den Stromsensor 5 angeschlossen. Weiterhin ist ein Speicher 15 vorgesehen, in dem Steuerinformationen und Steuerfelder abgelegt sind. Das Steuergerät 11 ist zudem über eine dritte Steuerleitung 16 mit dem Antrieb verbunden.

Das Steuergerät 11 steuert in bekannter Weise die Phasenströme für die Wicklungen 4 des elektrisch kommutierten Motors 3 entsprechend der gewünschten Drehzahl und dem gewünschten Drehmoment, das der Motor 3 an die elektromechanische Bremse 7 liefern soll. Dazu werden Betriebsparameter eines Kraftfahrzeuges 8 berücksichtigt, in dem die Schaltungsanordnung angeordnet ist. Zudem erfasst das Steuergerät 11 über den Stromsensor 5 den über die Stromleitung 2 dem Antrieb 3 zugeführten Strom. Dabei wird der Strom mit Referenzwerten verglichen und eine Fehlfunktion der Stromversorgung erkannt, wenn der erfasste Strom von den Referenzwerten mehr als einen vorgegebenen Differenzwert abweicht.

Der Eingang und der Ausgang des zweiten Stromsensors 12 sind über Messleitungen 36 mit einem A/D-Wandler 17 verbunden. Ein Ausgang 37 des A/D-Wandlers 17 ist an das Steuergerät 11 geführt.

Zur Überprüfung des Stromsensors 5 und der Stromversorgung des Antriebes 3 schaltet das Steuergerät 11 in einer Überprüfungsphase den Widerstand 12 an die Stromleitung 2 an, indem das Steuergerät 11 den zweiten Schalter 13 schließt und damit den Ausgang des Widerstandes 12 mit Masse verbindet. Vorzugsweise schaltet das Steuergerät 11 den im normalen Betrieb geschlossenen ersten Schalter 9 in eine Offenposition, so dass der Stromfluss nicht mehr über den Antrieb 3, sondern allein durch den zweiten Stromsensor 12 fließt. Das Steuergerät 11 erfasst bei der Überprüfungsphase sowohl die Spannung am Eingang als auch am Ausgang des Widerstandes 12. Aus dem Spannungsabfall über den Widerstand 12 ermittelt das Steuergerät 11 den durch den Stromsensor 5 fließenden Strom.

Aus der Kenntnis des Widerstandswertes des Widerstandes 12 berechnet das Steuergerät 11 den Strom, der dem Antrieb 3 zugeführt wird. Der über den zweiten Stromsensor 12 ermittelte Strom wird mit dem vom Stromsensor 5 ermittelten Strom verglichen. Ergibt der Vergleich, dass der vom Stromsensor 5 ermittelte Strom von dem Strom abweicht, der über den Spannungsabfall des Widerstandes 12 errechnet wurde, so erkennt das Steuergerät 11 eine Fehlfunktion des Stromsensors 5 und gibt beispielsweise ein Fehlersignal auf einem Anzeigesystem des Kraftfahrzeuges 8 aus. Zusätzlich kann das Steuergerät 11 in eine Notfunktion umschalten, um ein sicheres Anhalten des Kraftfahrzeuges 8 zu gewährleisten.

Die Überprüfung wird vorzugsweise zyklisch immer dann durchgeführt, wenn der Antrieb 3 nicht zur Betätigung der elektromechanischen Bremse 7 benötigt wird.

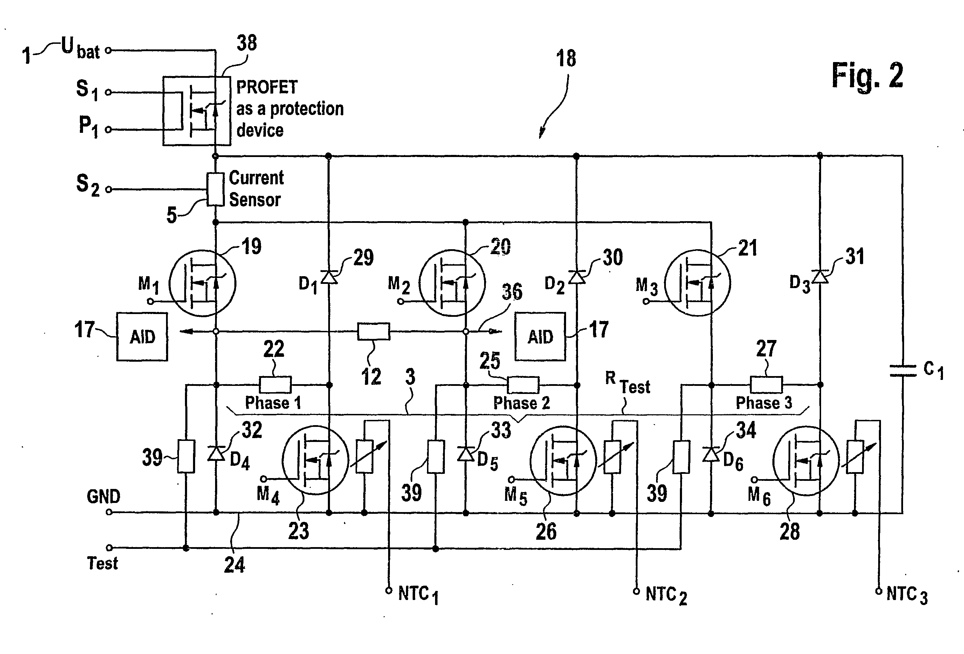

Fig. 2 zeigt eine weitere vorteilhafte Ausführungsform der erfindungsgemäßen Schaltungsanordnung, die vorzugsweise in einer Ansteuerschaltung für einen elektronisch kommutierten Motor 3 integriert ist. In vorteilhafter Weise ist der zweite Stromsensor 12 mit in die Ansteuerschaltung 18 integriert. Somit kann eine kostengünstige Realisierung der Schaltungsanordnung erreicht werden. Der Motor 3 ist nur schematisch in Form der drei Wicklungen 22, 25, 27 dargestellt.

Es ist eine Gleichspannungsquelle 1 vorgesehen, die über einen dritten Schalter 38 mit einem Eingang des Stromsensors 5 verbindbar ist. Ein Ausgang des Stromsensors 5 steht mit Eingängen eines ersten, zweiten und dritten Transistors 19, 20, 21 in Verbindung. Ein Ausgang des ersten Transistors 19 ist an einen Eingang einer ersten Wicklung 22 angeschlossen. Ein Ausgang der ersten Wicklung 22 ist an einen Eingang eines vierten Transistors 23 angeschlossen. Ein Ausgang des vierten Transistors 23 steht mit einer Masseleitung 24 in Verbindung.

Ein Ausgang des zweiten Transistors 20 steht mit einem Eingang einer zweiten Wicklung 25 in Verbindung. Ein Ausgang der zweiten Wicklung 25 steht mit einem Eingang eines fünften Transistors 26 in Verbindung. Ein Ausgang des fünften Transistors 26 ist mit der Masseleitung 24 verbunden. Ein Ausgang des dritten Transistors 21 ist an einen Eingang einer dritten Wicklung 27 angeschlossen. Ein Ausgang der dritten Wicklung 27 ist an einen Eingang eines sechsten Transistors 28 angeschlossen. Ein Ausgang des sechsten Transistors 28 ist an die Masseleitung 24 angeschlossen. Die Ausgänge der ersten, der zweiten und der dritten Wicklung 22, 25, 27 sind über eine erste, zweite bzw. dritte Diode 29, 30, 31 mit dem Eingang des Stromsensors 5 verbunden. Die Eingänge der ersten, der zweiten und der dritten Wicklung 22, 25, 27 sind über eine vierte, fünfte und sechste Diode 32, 33, 34 mit der Masseleitung 24 verbunden. Zwischen der Masseleitung 24 und dem Eingang des Stromsensors 5 ist ein Kondensator 35 geschaltet. Zudem sind noch Testwiderstände 39 parallel zur vierten, fünften bzw. sechsten Diode 32, 33, 34 geschaltet. Die Steueranschlüsse der Transistoren 19, 20, 21, 23, 26, 28 sind über Steuerleitungen mit dem Steuergerät 11 verbunden. Das Steuergerät 11 steuert in bekannter Art und Weise die Bestromung der Wicklungen 22, 25, 27, um über die Antriebsstange 6 eine gewünschte Drehzahl und/oder ein gewünschtes Drehmoment an die elektromechanische Bremse 7 abzugeben.

In der dargestellten Ausführungsform ist zwischen dem Eingang der ersten Spule 22 und dem Eingang der zweiten Spule 25 der zweite Stromsensor 12 in Form eines Widerstandes angeordnet. Die Anschlüsse des zweiten Stromsensors 12 stehen über Messleitungen 36 mit dem A/D-Wandler 17 des Steuergeräts 11 in Verbindung. Somit ist der zweite Stromsensor 12 ohne zusätzliche Schalter in einen bestehenden Stromkreis eingebracht. Aufgrund der Anordnung des zweiten Stromsensors 12 zwischen den Highside-Feldeffekttransistoren 19, 20 der ersten und der zweiten Wicklung 22, 25 macht sich der als Widerstand ausgebildete zweite Stromsensor 12 bei einer normalen Motorkommutierung nicht störend bemerkbar.

Bei einem Test des Stromsensors 5, der vorzugsweise bei einem Motorstillstand durchgeführt wird, wird der erste Transistor 19 und der fünfte Transistor 26 leitend geschaltet. Die übrigen Transistoren 20, 21, 23, 28 sind sperrend geschaltet. Bei diesem Schaltungszustand fließt ein Teststrom über den Stromsensor 5, den ersten Transistor 19, den zweiten Stromsensor 12, die zweite Wicklung 25 und den fünften Transistor 26 zur Masseleitung 24. Der über den zweiten Stromsensor 12 fließende Strom wird über den erfassten Spannungsabfall über den zweiten Stromsensor 12 berechnet. Der Widerstandswert des zweiten Stromsensors 12 ist bekannt und somit kann der Strom aus der Beziehung

$$U = R \times I$$

errechnet werden, wobei mit U der Spannungsabfall über den zweiten Stromsensor 12, mit R der Widerstandswert des zweiten Stromsensors 12 und mit I die Stromstärke bezeichnet ist.

Anstelle der in Fig. 2 dargestellten Anordnung kann der zweite Stromsensor 12 auch zwischen dem Eingang der ersten und dem Eingang der dritten Wicklung 22, 27 bzw. zwischen dem Eingang der zweiten und dem Eingang der dritten Wicklung 25, 27 angeordnet werden. In Abhängigkeit von der Anordnung des zweiten Stromsensors 12 sind entsprechende Transistoren bei der Überprüfung leitend zu schalten, damit ein Strom über den zweiten Stromsensor 12 und eine Wicklung fließt.

Im Testverfahren wird sowohl der Strom über den Stromsensor 5 erfasst als auch über den zweiten Stromsensor 12. Über einen Vergleich der zwei erfassten Ströme kann ein Defekt des ersten und/oder des zweiten Stromsensors 5, 12 erkannt werden.

**Patentansprüche**

1. Schaltungsanordnung mit einem Stromkreis zum Versorgen eines Verbrauchers, insbesondere eines elektrischen Antriebes, wobei ein Stromsensor (5) im Stromkreis vorgesehen ist, wobei ein Steuergerät (11) vorgesehen ist, das mit dem Stromsensor (5) verbunden ist, wobei das Steuergerät (11) über den Stromsensor (5) einen Stromfluss zum Verbraucher erfasst, **dadurch gekennzeichnet, dass** ein zweiter Stromsensor (12) vorgesehen ist, dass das Steuergerät (11) mit dem zweiten Stromsensor (12) verbunden ist, dass das Steuergerät (11) über den zweiten Stromsensor (12) den Stromfluss zum Verbraucher erfasst und durch einen Vergleich mit dem vom Stromsensor (5) erfassten Strom den Stromkreis überprüft.

2. Schaltungsanordnung nach Anspruch 1, **dadurch gekennzeichnet, dass** ein Schalter (9) vorgesehen ist, dass der Schalter (9) mit dem Steuergerät (11) verbunden ist und dass über den Schalter (9) der Verbraucher (3) vom Stromfluss abkoppelbar ist.

3. Schaltungsanordnung nach einem der Ansprüche 1 oder 2, **dadurch gekennzeichnet, dass** ein weiterer Schalter (13) vorgesehen ist, der mit dem Steuergerät (11) verbunden ist und dass über den weiteren Schalter (13) der zweite Stromsensor (12) in den Stromfluss schaltbar ist.

4. Schaltungsanordnung nach einem der Ansprüche 1 bis 3, **dadurch gekennzeichnet, dass** der zweite Stromsensor (12) in Form eines Widerstandes ausgebildet ist, dass ein Spannungsabfall über den Widerstand abgreifbar ist und dass das Steuergerät (11) den Spannungsabfall zur Überprüfung des Stromkreises verwendet.

5. Schaltungsanordnung nach einem der Ansprüche 1 bis 4, **dadurch gekennzeichnet, dass** der Verbraucher eine Wicklung (4, 22, 25, 27) eines elektrischen Antriebes (3) darstellt.

6. Schaltungsanordnung nach einem der Ansprüche 1 bis 5, **dadurch gekennzeichnet, dass** der Verbraucher einen Antrieb (3) für eine elektromechanische Bremse (7) darstellt.

7. Schaltungsanordnung nach Anspruch 5, **dadurch gekennzeichnet, dass** der elektrische Antrieb (3) wenigstens zwei Wicklungen (22, 25, 27) aufweist, dass jede Wicklung (22, 25, 27) über eine Eingangsleitung mit einem Eingangsschalter (19, 20, 21) verbunden ist, dass die Eingangsschalter (19, 20, 21) mit einem positiven Potenzial verbunden sind, dass jede Wicklung über je einen Ausgangsschalter (23, 26, 28) mit einem negativen Potenzial verbindbar ist und dass zwischen zwei Eingangsleitungen der zweite Stromsensor (12) angeschlossen ist.

8. Schaltungsanordnung nach Anspruch 7, **dadurch gekennzeichnet, dass** der zweite Stromsensor (12) als Widerstand ausgebildet ist, und dass mindestens eine Eingangsleitung an eine Spannungsmesseinheit (17) angeschlossen ist.

9. Schaltungsanordnung nach einem der Ansprüche 7 oder 8, **dadurch gekennzeichnet, dass** der zweite Stromsensor (12) in Serie mit einer Wicklung (25) schaltbar ist, und dass aus dem Spannungsabfall über den zweiten Stromsensor (12) ein im Stromkreis fließender Strom ermittelbar ist.

10. Verfahren zum Überprüfen einer Stromversorgung eines Verbrauchers, der über eine Eingangsleitung mit Strom versorgt wird, wobei in der Eingangsleitung ein erster Stromsensor (5) angeordnet ist, **dadurch gekennzeichnet, dass** in den Stromfluss vor oder nach dem Verbraucher (3) ein zweiter Stromsensor (12) angeordnet ist, dass über den Stromsensor (5) und den zweiten Stromsensor (12) ein Strom erfasst wird, und dass die erfassten Ströme miteinander verglichen werden und dass abhängig vom Vergleichsergebnis eine Fehlfunktion erkannt wird.

11. Verfahren nach Anspruch 10, **dadurch gekennzeichnet, dass** der zweite Stromsensor (12) über einen Schalter (13) in den Stromfluss geschaltet wird.

12. Verfahren nach Anspruch 10 oder 11, **dadurch gekennzeichnet, dass** der Verbraucher (3) über einen Schalter (9) vom Stromfluss abgekoppelt wird.

## Claims

1. Circuit arrangement comprising an electric circuit for supplying power to a load, in particular to an electric drive, with a current sensor (5) being provided in the electric circuit, with a control device (11) which is connected to the current sensor (5) being provided, with the control device (11) detecting a current flow to the load by means of the current sensor (5), **characterized in that** a second current sensor (12) is provided, **in that** the control device (11) is connected to the second current sensor (12), **in that** the control device (11) detects the current flow to the load by means of the second current sensor (12) and tests the electric circuit by comparing said current flow with the current detected by the current sensor (5).

2. Circuit arrangement according to Claim 1, **characterized in that** a switch (9) is provided, **in that** the switch (9) is connected to the control device (11), and **in that** the load (3) can be disconnected from the current flow by means of the switch (9).

3. Circuit arrangement according to either of Claims 1 and 2, **characterized in that** a further switch (13) which is connected to the control device (11) is provided, and **in that** the second current sensor (12) can be connected to the current flow by means of the further switch (13).

4. Circuit arrangement according to one of Claims 1 to 3, **characterized in that** the second current sensor (12) is in the form of a resistor, **in that** a voltage drop across the resistor can be tapped off, and **in that** the control device (11) uses the voltage drop to test the electric circuit.

5. Circuit arrangement according to one of Claims 1 to 4, **characterized in that** the load represents a winding (4, 22, 25, 27) of an electric drive (3).

6. Circuit arrangement according to one of Claims 1 to 5, **characterized in that** the load represents a drive (3) for an electromechanical brake (7).

7. Circuit arrangement according to Claim 5, **characterized in that** the electric drive (3) has at least two windings (22, 25, 27), **in that** each winding (22, 25, 27) is connected to an input switch (19, 20, 21) by means of an input line, **in that** the input switches (19, 20, 21) are connected to a positive potential, **in that** each winding can be connected to a negative potential by means of a respective output switch (23, 26, 28), and **in that** the second current sensor (12) is connected between two input lines.

8. Circuit arrangement according to Claim 7, **characterized in that** the second current sensor (12) is in the form of a resistor, and **in that** at least one input line is connected to a voltage measuring unit (17).

9. Circuit arrangement according to either of Claims 7 and 8, **characterized in that** the second current sensor (12) can be connected in series with a winding (25), and **in that** a current flowing in the electric circuit can be determined from the voltage drop across the second current sensor (12).

10. Method for testing a current supply to a load which is supplied with current by means of an input line, with a first current sensor (5) being arranged in the input line, **characterized in that** a second current sensor (12) is arranged in the current flow upstream or downstream of the load (3), **in that** a current is detected by means of the current sensor (5) and the second current sensor (12), and **in that** the detected currents are compared with one another, and **in that** a malfunction is identified depending on the result of the comparison.

11. Method according to Claim 10, **characterized in that** the second current sensor (12) is connected to the current flow by means of a switch (13).

12. Method according to Claim 10 or 11, **characterized in that** the load (3) is disconnected from the current flow by means of a switch (9).


**Revendications**

1. Dispositif comportant un circuit électrique pour alimenter un utilisateur, notamment un moyen d'entraînement électrique, comprenant
un capteur de courant (5) installé dans le circuit électrique,
un appareil de commande (11) relié au capteur de courant (5),
l'appareil de commande (11) captant l'intensité du courant alimentant l'utilisateur par l'intermédiaire du capteur de courant (5),
**caractérisé par**
un second capteur de courant (12),
l'appareil de commande (11) étant relié au second capteur de courant (12),
l'appareil de commande (11) captant l'intensité du courant vers l'utilisateur par l'intermédiaire du second capteur de courant (12) et par comparaison avec l'intensité du courant captée par le capteur de courant (5) il vérifie le circuit électrique.

2. Dispositif selon la revendication 1,
**caractérisé par**
un commutateur (9),
le commutateur (9) est relié à l'appareil de commande (11) et
l'utilisateur (3) peut être coupé de l'alimentation en courant par le commutateur (9).

3. Dispositif selon l'une des revendications 1 ou 2,
**caractérisé par**
un autre commutateur (13) relié à l'appareil de commande (11) et qui peut commuter le second capteur de courant (12) dans le circuit électrique par le second commutateur (13).

4. Dispositif selon l'une des revendications 1 à 3,
**caractérisé en ce que**
le second capteur de courant (12) est réalisé sous la forme d'une résistance,
une chute de tension se détecte aux bornes de la résistance et
l'appareil de commande (11) utilise la chute de tension pour contrôler le circuit électrique.

5. Dispositif selon l'une des revendications 1 à 4,
**caractérisé en ce que**
l'utilisateur est l'enroulement (4, 22, 25, 27) d'un moyen d'entraînement électrique (3).

6. Dispositif selon l'une des revendications 1 à 5,
**caractérisé en ce que**
l'utilisateur est le moyen d'entraînement (3) d'un frein électromagnétique (7).

7. Dispositif selon la revendication 5,
**caractérisé en ce que**
le moyen d'entraînement électrique (3) comporte au moins deux enroulements (22, 25, 27),
chaque enroulement (22, 25, 27) est relié par une ligne d'alimentation propre à un commutateur d'entrée (19, 20, 21),
les commutateurs d'entrée (19, 20, 21) étant reliés à un potentiel positif,
chaque enroulement pouvant être relié par un commutateur de sortie (23, 26, 28) respectif à un potentiel négatif et
le second capteur de courant (12) est prévu entre deux lignes d'entrée.

8. Dispositif selon la revendication 7,
**caractérisé en ce que**
le second capteur de courant (12) est réalisé sous la forme d'une résistance et au moins une ligne d'entrée est reliée à une unité de mesure de tension (17).

9. Dispositif selon l'une des revendications 7 ou 8,
**caractérisé en ce que**
le second capteur de courant (12) est branché en série sur un enroulement (25) et

à partir de la chute de tension, le second capteur de courant (12) détermine l'intensité du courant passant dans le circuit électrique.

10. Procédé de contrôle d'une alimentation électrique d'un utilisateur alimentée en courant par une ligne d'entrée,

la ligne d'entrée étant équipée d'un premier capteur de courant (5),

**caractérisé par**

un second capteur de courant (12) installé en amont ou en aval de l'utilisateur (3) selon le passage du courant, et le capteur de courant (5) ainsi que le second capteur de courant (12) captent une intensité de courant et

les intensités de courant captées sont comparées et en fonction du résultat de la comparaison, on décèle un fonctionnement défectueux.

11. Procédé selon la revendication 10,
**caractérisé en ce que**
le second capteur de courant (12) est branché dans le passage du courant par l'intermédiaire d'un commutateur (13).

12. Procédé selon la revendication 10 ou 11,
**caractérisé en ce que**
l'utilisateur (3) est découplé de l'alimentation en courant par un commutateur (9).

## Fig. 1

Fig. 2

EP 1 490 700 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3934239 A